# EUROPÄISCHE PATENTSCHRIFT

(11) **EP 3 304 097 B1**
(45) Veröffentlichungstag und Bekanntmachung des Hinweises auf die Patenterteilung: **13.03.2024**
(21) Anmeldenummer: 16733913.4
(22) Anmeldetag: 24.06.2016
(51) Int. Cl.: G01R 15/18, H01F 38/30, G01R 19/00

(54) **NULLFLUSSSTROMWANDLER**
ZERO FLUX CURRENT TRANSFORMER
TRANSFORMATEUR DE COURANT À FLUX NUL

(30) Priorität: 24.07.2015 DE 102015214043
(43) Veröffentlichungstag der Anmeldung: 11.04.2018
(73) Patentinhaber: Siemens Energy Global GmbH & Co. KG, 81739 München (DE)
(72) Erfinder: ARMSCHAT, Christoph, 91058 Erlangen (DE); KUNDE, Kerstin, 91301 Forchheim (DE); PRUCKER, Udo, 90571 Schwaig (DE)
(86) Internationale Anmeldenummer: PCT/EP2016/064687
(87) Internationale Veröffentlichungsnummer: WO 2017/016769

(56) Entgegenhaltungen:
- WO-A1-98/16839
- CN-B- 102 496 446
- CN-U- 203 241 471
- CN-U- 203 551 641
- DE-A1- 3 540 547
- JP-A- 2002 286 763

## Beschreibung

Die Erfindung betrifft einen Nullflussstromwandler, der eine Kompensationswicklung und eine Detektionswicklung aufweist.

Mittels eines Nullflussstromwandlers (Zero Flux Current Transformer) wird ein in einem Leiter (sogenannter Primärleiter) fließender Strom gemessen. Der Nullflussstromwandler weist eine elektrische Detektionswicklung auf, mit der der durch den fließenden Strom erzeugte, den Leiter umgebende, magnetische Fluss gemessen wird. Der Nullflussstromwandler weist weiterhin eine elektrische Kompensationswicklung auf, mit der der magnetische Fluss zu Null kompensiert wird. Mittels einer Regelschaltung und einer Verstärkerschaltung wird der durch die Kompensationswicklung fließende Strom (Kompensationsstrom) so eingestellt, dass der magnetische Fluss des Leiters stets zu Null kompensiert wird (sogenannte Nullflussbedingung). Die Größe des zum Erreichen der Nullflussbedingung benötigten Kompensationsstroms ist ein Maß für die Größe des durch den Leiter fließenden Stroms, d.h. für die Größe des zu messenden Stroms.

Aufgrund des hohen Energiebedarfs der Kompensationswicklung und der Verstärkerschaltung werden Nullflussstromwandler in der Regel auf Erdpotential betrieben. Wenn der durch einen auf Hochspannungspotential liegenden Leiter (Hochspannungsleiter) fließende Strom gemessen werden soll, dann wird eine elektrische Isolation zwischen dem Leiter und dem Nullflussstromwandler benötigt. Je größer das Hochspannungspotential ist, desto höher sind die Anforderungen an diese elektrische Isolation.

Eine Möglichkeit zur Realisierung dieser elektrischen Isolation wäre die Verwendung einer horizontal angeordneten Hochspannungs-Wanddurchführung. Die Kompensationswicklung und die Detektionswicklung des Nullflussstromwandlers würden im Außenraum um die Wanddurchführung herum angeordnet werden. Eine Hochspannungs-Wanddurchführung als solche wird dann verwendet, wenn ein Hochspannungsleiter durch eine senkrecht stehende Wand hindurchgeführt werden soll. Eine solche Wanddurchführung weist zwei horizontal (waagerecht) ausgerichtete, meterlange Isolatoren auf, welche sich von der Wand ausgehend in entgegengesetzten Richtungen erstrecken. Dadurch benötigt eine Anordnung mit einer waagerecht ausgestalteten Wanddurchführung viel Platz, d. h. sie hat einen großen Platzbedarf. Außerdem besteht insbesondere dann ein hoher zusätzlicher Materialaufwand, wenn am Ort der Strommessung gar keine Wanddurchführung benötigt wird. Daher wäre die Lösung mit einer waagerecht angeordneten Hochspannungs-Wanddurchführung aufwendig und teuer.

Eine weitere Möglichkeit zur Realisierung der benötigten Spannungsisolation wäre die Isolation mittels eines Ölbads (Ölisolation). Allerdings kann bei einer Ölisolation im Fehlerfall Öl auslaufen (Grundwassergefährdung), das Öl kann sich im Fehlerfall entzünden und bei einem schweren Fehler als brennendes Öl durch die Umgebung gespritzt werden. Dadurch kann es zu einer erheblichen Gefährdung von Personen, Anlagen und/oder Gebäuden kommen. Daher ist oftmals eine Erhöhung der Brandlast durch eine Ölisolation nicht erwünscht bzw. erfordert aufwendige und teure Schutzmaßnahmen.

Aus der Schrift CN 102 496 446 B ist ein Nullflussstromwandler bekannt, der von einem Stützisolator getragen wird.

Die Offenlegungsschrift DE 35 40 547 A1 offenbart einen Hochspannungsstromwandler in Kopfbauweise, der von einer Säule aus Isoliermaterial getragen wird.

Die Schrift CN 203 551 641 U offenbart eine Breitband-Messeinrichtung mit einem Nullflussstromsensor und einer Rogowskispule.

Die Schriften CN 203 241 471 U, WO 98/16839 A1 und JP 2002 286763 A offenbaren jeweils Messeinrichtungen, die zusätzlich zu einer herkömmlichen Messpule eine kernlose Messpule aufweisen.

Der Erfindung liegt die Aufgabe zugrunde, eine Anordnung mit einem Nullflussstromwandler anzugeben, die einfach und/oder preiswert realisiert werden kann.

Diese Aufgabe wird erfindungsgemäß gelöst durch eine Anordnung nach dem unabhängigen Patentanspruch. Vorteilhafte Ausgestaltungen der Anordnung sind in den abhängigen Patentansprüchen angegeben.

Offenbart wird eine Anordnung mit einem Nullflussstromwandler, der eine Kompensationswicklung und eine Detektionswicklung aufweist, wobei die Kompensationswicklung und die Detektionswicklung in einem Gehäuse angeordnet sind, das von einem vertikal ausgerichteten Stützisolator abgestützt ist. Hierbei ist vorteilhaft, dass das Gehäuse von dem vertikal ausgerichteten Stützisolator abgestützt ist. Im Gegensatz zu einer waagerechten Wanddurchführung benötigt ein vertikal ausgerichteter Stützisolator wesentlich weniger Grundfläche. Über die Länge des Stützisolators lässt sich die Spannungsisolation an den benötigten Wert anpassen. Ein weiterer Vorteil besteht darin, dass ein vertikal ausgerichteter Nullflussstromwandler im Vergleich zu einer horizontal ausgerichteten Durchführung geringere Abmessungen hat und daher kostengünstiger hergestellt werden kann.

Die Anordnung ist so ausgestaltet, dass im Inneren des Gehäuses ein Kerngehäuse angeordnet ist, welches die Kompensationswicklung und die Detektionswicklung umgibt. Mittels dieses Kerngehäuses lässt sich das elektrische Potential in der Umgebung der Kompensationswicklung und der Detektionswicklung festlegen.

Die Anordnung ist so ausgestaltet, dass das Kerngehäuse mit Erdpotential verbunden ist. Dadurch wird vorteilhafterweise sichergestellt, dass die Kompensationswicklung und die Detektionswicklung potentialbezogen in der Nähe des Erdpotentials liegen.

Die Anordnung ist so ausgestaltet, dass das Kerngehäuse gegenüber dem Gehäuse elektrisch isoliert ist. Mittels einer elektrischen Isolierung zwischen dem Kerngehäuse und dem Gehäuse wird das Hochspannungspotential des zu messenden Stroms (das im Wesentlichen auch am Gehäuse anliegt) gegenüber dem Erdpotential (das am Kerngehäuse anliegt) elektrisch isoliert.

Die Anordnung ist auch so ausgestaltet, dass das Kerngehäuse mittels SF₆-Gas gegenüber dem Gehäuse elektrisch isoliert ist. Die elektrische Isolierung zwischen dem Kerngehäuse und dem Gehäuse (und damit die elektrische Isolierung zwischen dem Hochspannungspotential des zu messenden Stroms und dem Erdpotential) erfolgt vorteilhafterweise mittels des Gases SF₆ (Schwefelhexafluorid). Dadurch wird vorteilhafterweise erreicht, dass im Havariefall schlimmstenfalls (nicht brennbares) Schwefelhexafluorid aus dem Gehäuse austreten kann. Im Unterschied zu einer Ölisolierung besteht jedoch nicht die Gefahr, dass sich Öl im Havariefall entzünden und brennend verspritzt werden könnte.

Die Anordnung ist auch so ausgestaltet, dass das Kerngehäuse mittels eines isolierenden Abstandshalters in dem Gehäuse gehaltert/befestigt ist. Mittels des isolierenden Abstandshalters kann eine robuste mechanische Halterung /Befestigung des Kerngehäuses in dem Gehäuse realisiert werden. Insbesondere lassen sich mittels eines oder mehrerer isolierender Abstandshalter auch vergleichsweise große und schwere Kerngehäuse in dem Gehäuse befestigen.

Die Anordnung ist auch so ausgestaltet, dass das Kerngehäuse mittels eines metallischen Rohrs mit Erdpotential verbunden ist. Mittels des metallischen Rohrs wird vorteilhafterweise zum einen das Kerngehäuse mit Erdpotential verbunden, zum anderen werden im Inneren des metallischen Rohrs elektrische Leitungen (Messleitungen, beispielsweise die Zuleitungen der Kompensationswicklung und der Detektionswicklung) von dem Kerngehäuse zum auf Erdpotential liegenden Anschlusskasten geführt.

Die Anordnung ist auch so ausgestaltet, dass das metallische Rohr zumindest teilweise von einer Potentialabsteuereinrichtung (Einrichtung zum Absteuern des elektrischen Potentials) umgeben ist. Mittels dieser Potentialabsteuereinrichtung kann die Potentialdifferenz zwischen dem metallischen Rohr (Erdpotential), dem Stützisolator und dem stromführenden Leiter (Hochspannungsleiter) kontrolliert abgebaut/verringert werden. Potentialabsteuereinrichtungen als solche sind bekannt. Potentialabsteuereinrichtungen weisen beispielsweise mehrere (beabstandete und gegeneinander isolierte) konzentrische Lagen eines oder mehrerer in ihren elektrischen Eigenschaften passend abgestimmten Medien auf, um das elektrische Feld gezielt zu steuern und unerwünschte Feldkonzentrationen zu vermeiden.

Die Anordnung kann auch so ausgestaltet sein, dass das metallische Rohr zumindest teilweise von dem Stützisolator umgeben ist. Dabei nimmt vorteilhafterweise der Stützisolator im Wesentlichen die Gewichtskräfte des Gehäuses und des Kerngehäuses auf.

Die Anordnung kann auch so ausgestaltet sein, dass der Stützisolator ein Hohlisolator, insbesondere ein mit Schirmen versehener Hohlisolator, ist. Ein derartiger Hohlisolator kann vorteilhafterweise sowohl in Innenräumen als auch im Freien aufgestellt werden.

Die Anordnung kann auch so ausgestaltet sein, dass das Gehäuse mit SF₆-Gas gefüllt ist. Durch Füllung des Gehäuses mit dem Gas SF₆ kann auf einfache Weise eine gute elektrische Isolation zwischen dem Gehäuse und den in dem Gehäuse angeordneten Komponenten (z. B. Kerngehäuse mit Kompensationswicklung, Detektionswicklung) realisiert werden.

Die Anordnung kann so ausgestaltet sein, dass die Detektionswicklung eine eisenkernbehaftete Detektionswicklung ist und der Nullflussstromwandler zusätzlich eine eisenkernlose Detektionswicklung aufweist. Mit dem Begriff "eisenkernbehaftete Detektionswicklung" ist hier eine elektrische Wicklung gemeint, die einen Eisenkern umschließt. Man könnte diese Detektionswicklung auch als eine "Eisenkern-Detektionswicklung" bezeichnen. Die eisenkernlose Detektionswicklung weist im Unterschied dazu keinen Eisenkern auf. Es handelt sich also um eine Luftspule (die auch als Rogowskispule bezeichnet wird). Vorteilhafterweise weist der Nullflussstromwandler also eine Detektionswicklung mit Eisenkern (eisenkernbehaftete Detektionswicklung) und eine Detektionswicklung ohne Eisenkern (eisenkernlose Detektionswicklung) auf. Mittels der eisenkernbehafteten Detektionswicklung kann vorteilhafterweise ein Gleichstrom (insbesondere ein Hochspannungs-Gleichstrom) gemessen werden oder es können mit der eisenkernbehafteten Detektionswicklung Wechselströme mit relativ niedrigen Frequenzen (hier: Frequenzen > 0 und ≤ 30 kHz gemessen werden. Solche Wechselströme können beispielsweise dem Gleichstrom überlagerte Ströme sein. Solche Ströme werden im Folgenden auch kurz als "überlagerte Ströme" bezeichnet. Solche überlagerten Ströme können zum Beispiel bei der Umwandlung von Wechselstrom in Gleichstrom entstehen. Für die Messung von Wechselströmen (beispielsweise überlagerten Strömen) höherer Frequenz (hier sind dies Frequenzen > 30 kHz und ≤ 1 MHz) wird jedoch die eisenkernlose Detektionswicklung verwendet. Es hat sich nämlich herausgestellt, dass bei hohen Frequenzen > 30 kHz die induktiven Energiespeicher der Eisenkerne die Messung verfälschen können. Durch die Verwendung sowohl der eisenkernbehafteten Detektionswicklung als auch der eisenkernlosen Detektionswicklung in einem Nullflussstromwandler wird also der Frequenzbereich der Strommessung erheblich vergrößert.

Die Anordnung kann auch so ausgestaltet sein, dass die eisenkernbehaftete Detektionswicklung mit einer ersten Messschaltung zum Messen von Gleichstrom elektrisch verbunden ist und die eisenkernlose Detektionswicklung mit einer zweiten Messschaltung zum Messen von Wechselstrom elektrisch verbunden ist. Mittels der ersten Messschaltung wird also vorteilhafterweise mindestens der Gleichstrom gemessen; mittels der zweiten Messschaltung wird der Wechselstrom gemessen.

Die Anordnung kann auch so ausgestaltet sein, dass die zweite Messschaltung zum Messen von Wechselströmen mit Frequenzen zwischen ca. 10 kHz und 1 MHz, insbesondere zum Messen von Wechselströmen mit Frequenzen zwischen ca. 30 kHz und 1 MHz, eingerichtet ist. Mittels der zweiten Messschaltung werden also Wechselströme zwischen 10 kHz und 1 MHz gemessen, insbesondere werden mit der zweiten Messschaltung Wechselströme zwischen 30 kHz und 1 MHz gemessen.

Die Anordnung kann auch so ausgestaltet sein, dass die erste Messschaltung zum Messen von Gleichstrom und zum Messen von Wechselströmen mit Frequenzen zwischen Null und ca. 30 kHz eingerichtet ist. Dabei ist vorteilhaft, dass die erste Messschaltung nicht nur zum Messen von Gleichstrom, sondern auch zum Messen von Strömen mit Frequenzen von 0 bis zu 30 kHz eingerichtet ist. Bis zu Frequenzen von 30 kHz lassen sich Strommessungen nämlich auch mit einer eisenkernbehafteten Detektionswicklung noch zufriedenstellend durchführen.

Im Übergangsbereich (das ist hier der Bereich zwischen ca. 10 kHz und 30 kHz) kann die Strommessung wahlweise mit der ersten Messschaltung oder der zweiten Messschaltung oder auch mit beiden Messschaltungen parallel durchgeführt werden.

Offenbart wird weiterhin eine Hochspannungs-Gleichstrom-Übertragungs-Einrichtung (HGÜ-Einrichtung) mit einer der vorstehend genannten Anordnungen. Die genannten Anordnungen mit dem Nullflussstromwandler können nämlich mit Vorteil in Hochspannungs-Gleichstrom-Übertragungseinrichtungen eingesetzt werden, um die Größe des Hochspannungsgleichstromes des Gleichstromkreises, die Größe von dem Hochspannungsgleichstrom überlagerten Wechselströmen und Gleichströmen und/oder die Größe von überlagerten Wechselströmen und Gleichströmen in Transformatorströmen auf der Netzseite und auf der Umrichterseite zu messen. Insbesondere im Transformatorstrom ist die Messung von kleinsten Gleichstrom-Anteilen von großer Wichtigkeit, da diese soweit möglich auf Null ausgeregelt werden sollen.

Offenbart wird weiterhin ein Verfahren zum Messen von Strömen mittels eines Nullflussstromwandlers, bei dem mittels einer eisenkernbehafteten Detektionswicklung des Nullflussstromwandlers ein Gleichstrom gemessen wird und mittels einer eisenkernlosen Detektionswicklung des Nullflussstromwandlers ein Wechselstrom (insbesondere ein dem Gleichstrom überlagerter Störstrom) gemessen werden.

Dieses Verfahren kann auch so ausgestaltet sein, dass der Wechselstrom eine Frequenz zwischen ca. 10 kHz und 1 MHz aufweist.

Dieses Verfahren kann so ausgestaltet sein, dass mittels der eisenkernbehafteten Detektionswicklung zusätzlich ein Wechselstrom, insbesondere ein dem Gleichstrom überlagerter Wechselstrom, gemessen wird.

Das Verfahren weist gleichartige Vorteile auf, wie sie oben im Zusammenhang mit der Anordnung beschrieben sind.

Im Folgenden wird die Erfindung anhand eines Ausführungsbeispiels näher erläutert. Dazu ist in
- Figur 1: ein Ausführungsbeispiel einer Anordnung mit einem Nullflussstromwandler, in
- Figur 2: eine vergrößerte Darstellung eines beispielhaften Gehäuses des Nullflussstromwandlers, in
- Figur 3: ein Ausführungsbeispiel eines Kerngehäuses des Nullflussstromwandlers und in
- Figur 4: ein Ausführungsbeispiel eines nicht beanspruchten Verfahrens zur Strommessung mittels des Nullflussstromwandlers
dargestellt.

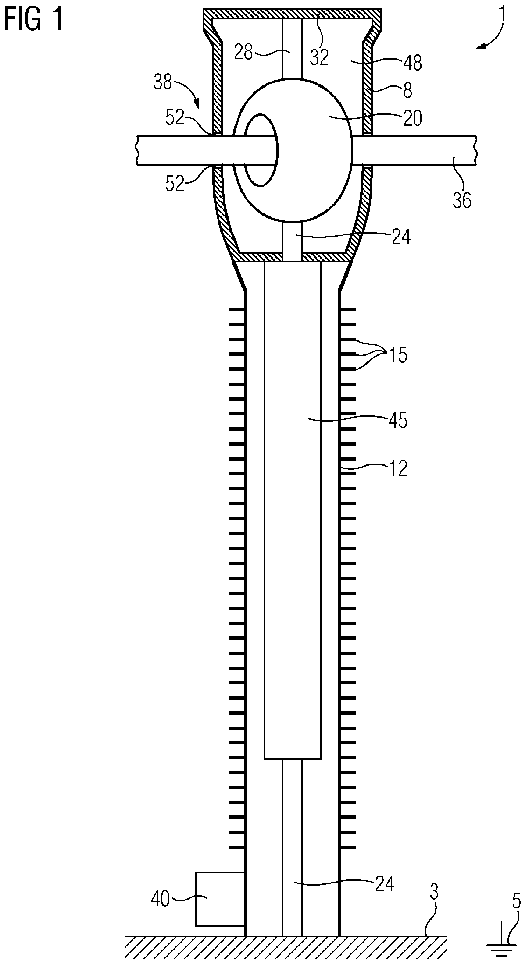

In Figur 1 ist in einer teilweisen Schnittdarstellung ein Ausführungsbeispiel eines Nullflussstromwandlers 1 dargestellt. Der Nullflussstromwandler 1 steht auf einer Oberfläche 3, die Erdpotential 5 aufweist. Bei der Oberfläche 3 kann es sich beispielsweise um die Erdoberfläche, ein Betonfundament oder ein Stahlgerüst handeln. Der Nullflussstromwandler 1 weist ein Gehäuse 8 (äußeres Gehäuse 8, Kapselungsgehäuse 8) auf, welches von einem vertikal angeordneten Stützisolator 12 abgestützt ist. Der Stützisolator 12 ist als ein Hohlisolator 12 ausgebildet. Der Stützisolator 12 weist eine Vielzahl von Schirmen 15 auf und besteht im Ausführungsbeispiel aus einem Kompositmaterial (Verbundmaterial aus mindestens zwei verbundenen Materialien). Der Stützisolator weist z.B. ein glasfaserverstärktes Kunststoffrohr und Silikonrippen auf. Das Gehäuse 8 besteht im Ausführungsbeispiel aus Metall.

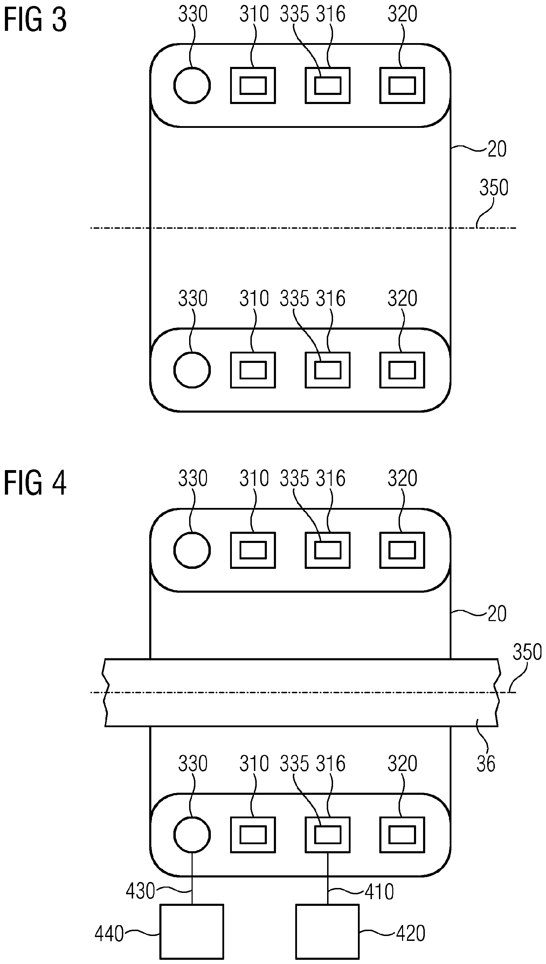

Das Gehäuse 8 wird auch als Stromwandlerkopf bezeichnet. Im Inneren des Gehäuses 8 ist ein Kerngehäuse 20 (inneres Gehäuse 20) angeordnet, welches mit einem metallischen Rohr 24 verbunden ist. Zusätzlich ist das Kerngehäuse 20 mittels eines isolierenden Abstandshalters 28 an dem Gehäuse 8 befestigt, genauer gesagt an einem Deckel 32 des Gehäuses 8. In dem Kerngehäuse 20 (und damit auch in dem Gehäuse 8) sind eine Kompensationswicklung 310 und eine Detektionswicklung 316 (vgl. Figur 3)angeordnet. Zusätzlich sind im Kerngehäuse 20 noch weitere Wicklungen 320, 330 angeordnet. Das Kerngehäuse 20 besteht im Ausführungsbeispiel aus Aluminium.

Das Kerngehäuse 20 (und die in dem Kerngehäuse 20 angeordneten Wicklungen 310, 316, 320 und 330) umschließen einen Leiter 36 (Primärleiter). Durch den Leiter 36 fließt der zu messende Strom (Messstrom, Primärstrom). Der Leiter 36 liegt auf einem Hochspannungspotential 38. Bei dem zu messenden Strom handelt es sich im Ausführungsbeispiel um einen Hochspannungsgleichstrom, dem Wechselströme überlagert sind. Derartige Wechselströme können beispielsweise Oberwellen sein, die beim Umrichten von Hochspannungswechselstrom in Hochspannungsgleichstrom entstehen (überlagerte Ströme).

Die Anschlüsse der in dem Kerngehäuse 20 angeordneten Wicklungen (also insbesondere die Anschlüsse der Wicklungen 310, 316, 320 und 330, vgl. Figur 3) verlaufen durch das metallische Rohr 24 hindurch zu einem Anschlusskasten 40, der nahe der Oberfläche 3 angeordnet ist und auf Erdpotential liegt. An diesem Anschlusskasten 40 können die durch die einzelnen Wicklungen fließenden Ströme aus dem Nullflussstromwandler herausgeführt und den jeweiligen Messschaltungen zugeführt werden.

Der dem Gehäuse 8 benachbarte Abschnitt des Rohrs 24 ist von einer Potentialabsteuereinrichtung 45 umgeben. Mittels dieser Potentialabsteuereinrichtung 45 wird sichergestellt, dass die Potentialunterschiede zwischen dem Gehäuse 8, dem Stützisolator 12 und dem auf Erdpotential 5 liegenden Rohr 24 kontrolliert abgebaut werden. Das metallische Rohr 24 und die Potentialabsteuereinrichtung 45 sind mindestens teilweise von dem Stützisolator 12 umgeben.

Das Kerngehäuse 20 ist mittels des metallischen Rohrs 24 mit der Oberfläche 3 (und damit mit Erdpotential 5) elektrisch verbunden, das Kerngehäuse 20 befindet sich also auf Erdpotential 5. Das Gehäuse 8 befindet sich auf Hochspannungspotential 38. Um das Kerngehäuse 20 gegenüber dem Gehäuse 8 elektrisch zu isolieren, ist das Gehäuse 8 mit dem Gas SF₆ gefüllt (Gasfüllung 48). Das Gehäuse 8 ist mit einer Berstplatte versehen, durch die bei Überdruck die Gasfüllung 48 austreten kann, ohne das Gehäuse 8 als solches zu zerstören.

Zwischen dem Gehäuse 8 und dem Leiter 36 sind an der Stelle 52 gasdichte Dichtungselemente angeordnet, die in der Figur 1 der besseren Übersichtlichkeit halber nicht dargestellt sind. Diese Dichtungselemente 52 sorgen dafür, dass das SF₆-Gas der Gasfüllung 48 nicht aus dem Gehäuse 8 entweichen kann. Der Leiter 36 ist an einer Eintrittstelle in das Gehäuse 8 gegenüber dem Gehäuse 8 elektrisch isoliert.

Das Kerngehäuse 20 (welches aus einem Metall, insbesondere aus Aluminium, besteht) schirmt vorteilhafterweise äußere Magnetfelder von den Wicklungen ab. Durch in dem Kerngehäuse 20 angeordnete Isolierschlitze werden umlaufende Wirbelströme vermieden, welche das Messsignal verfälschen würden. Mittels des Gehäuses 8 wird eine weitere Abschirmung von äußeren magnetischen Feldern erreicht. Dadurch kann der Nullflussstromwandler auch in der Nähe von Magnetfelderzeugern aufgestellt werden, beispielsweise in der Nähe von Drosseln oder Transformatoren, ohne dass die Strommessung nennenswert verfälscht wird.

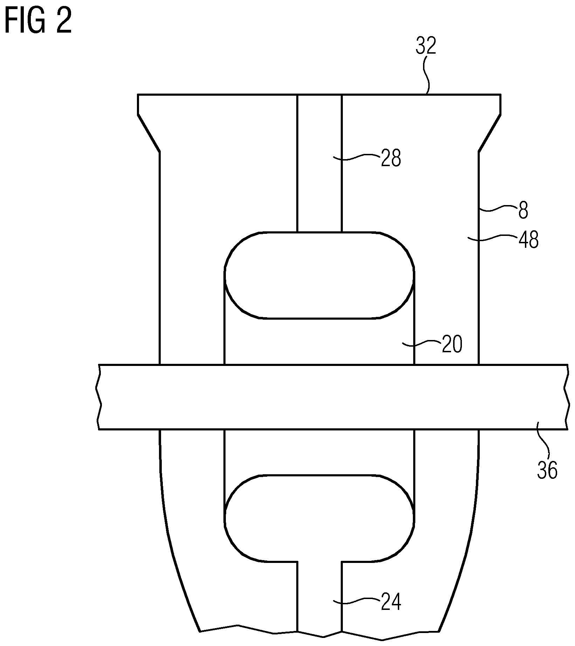

In Figur 2 ist eine Schnittdarstellung des Gehäuses 8 dargestellt. Hierbei ist gut zu erkennen, dass das Rohr 24 in das Kerngehäuse 20 einmündet, so dass die in dem Kerngehäuse 20 angeordneten Wicklungen mit in dem Rohr 24 verlegten Messleitungen mit dem Anschlusskasten 40 verbunden werden können. Weiterhin ist gut zu erkennen, dass der Leiter 36 von dem torusförmigen Kerngehäuse 20 umschlossen wird.

In Figur 3 ist in einer schematischen Schnittdarstellung das Kerngehäuse 20 dargestellt, wobei die Kompensationswicklung 310 die erste Detektionswicklung 316, eine zweite Detektionswicklung 320 sowie eine dritte Detektionswicklung 330 sichtbar sind. Die Kompensationswicklung 310, die erste Detektionswicklung 316 und die zweite Detektionswicklung 320 sind eisenkernbehaftete Wicklungen, d. h. sie sind auf einen Eisenkern gewickelt. So ist beispielsweise die erste Detektionswicklung 316 auf den Eisenkern 335 gewickelt. In der Darstellung der Figur 3 ist der Eisenkern jeweils als kleines Quadrat und die auf den Eisenkern aufgewickelte Wicklung als größeres Quadrat symbolhaft dargestellt. Die Wicklungen 310, 316 und 320 sowie die zugehörigen Eisenkerne haben jeweils einen quadratischen Querschnitt. Die dritte Detektionswicklung 330 ist eine eisenkernlose Detektionswicklung (Rogowskispule 330, Luftspule 330). Diese weist im Ausführungsbeispiel der Figur 3 einen runden Querschnitt auf und ist mittels eines Kreises dargestellt. Das Kerngehäuse 20 ist im Wesentlichen rotationssymmetrisch bezüglich der Rotationsachse 350.

In Figur 4 ist das Kerngehäuse 20 und der von dem Kerngehäuse 20 umschlossenen Leiter 36 dargestellt. Weiterhin ist schematisch dargestellt, dass die erste Detektionswicklung 316 mittels einer ersten Messleitung 410 (über den nicht dargestellten Anschlusskasten 40) mit einer ersten Messschaltung 420 elektrische verbunden ist. Weiterhin ist die dritte Detektionswicklung 330 mittels einer zweiten Messleitung 430 (über den nicht dargestellten Anschlusskasten 40) mit einer zweiten Messschaltung 440 elektrisch verbunden.

Die erste Messschaltung 420 ist dazu eingerichtet, einen Gleichstrom sowie Wechselströme mit Frequenzen zwischen 0 und ca. 30 kHz zu messen. Derartige Wechselströme können beispielsweise dem Gleichstrom überlagerte Wechselströme sein. Die zweite Messschaltung 440 ist dazu eingerichtet, Wechselströme mit Frequenzen zwischen 10 kHz und 1 MHz zu messen. Die zweite Messschaltung 440 ist insbesondere dazu eingerichtet, Wechselströme mit Frequenzen zwischen 30 kHz und 1 MHz zu messen. Mittels der ersten (eisenkernbehafteten) Detektionswicklung 316 und der ersten Messschaltung 420 werden also der Gleichstrom und Wechselströme mit Frequenzen bis ca. 30 kHz gemessen. Mittels der dritten (eisenkernlosen) Detektionswicklung 330 und der zweiten Messschaltung 440 werden ausschließlich Wechselströme mit Frequenzen zwischen 10 kHz und 1 MHz, insbesondere Frequenzen zwischen 30 kHz und 1 MHz, gemessen.

Mittels der eisenkernlosen Detektionswicklung 330 können also vorteilhafterweise auch höhere Frequenzanteile im zu messenden Strom gemessen werden. Es lassen sich mittels dieser eisenkernlosen Detektionswicklung Ströme bis ca. 1 MHz messen. Dies ist insbesondere bei den Themen RFI (Radio Frequency Interference, Überlagerung von elektromagnetischen Wellen) und EMV (elektromagnetische Verträglichkeit) bei Hochspannungsanlagen mit geforderten niedrigen elektromagnetischen Störpegeln von Vorteil. Weitere vorteilhafte Anwendungsmöglichkeiten bestehen bei der Messung der harmonischen und dynamischen Performance von Hochspannungsanlagen.

Durch den zusätzlichen Einbau der eisenkernlosen Detektionswicklung 330 wird folgender Nachteil der eisenkernbehafteten Detektionswicklung 316 überwunden: Aufgrund der hohen elektrischen Isolationsanforderungen hat das Kerngehäuse 20 mit den Wicklungen einen relativ großen Durchmesser. Daher weist auch der Eisenkern 335 der eisenkernbehafteten Detektionswicklung 316 einen großen Durchmesser auf. Folglich ergeben sich bei der eisenkernbehafteten Detektionswicklung 316 nennenswerte Reaktanzen und Streukapazitäten. Diese begrenzen den Frequenzgang des Nullflussstromwandlers bei Hochspannungsanwendungen.

Mit dem beschriebenen Nullflussstromwandler können Ströme von beispielsweise bis zu 5000 A gemessen werden bei einer Spannung von beispielsweise bis zu ca. 600 kV.

Der beschriebene SF₆-gekapselte vertikale Nullflussstromwandler benötigt (im Vergleich zu einem waagerecht angeordneten Nullflussstromwandler) eine wesentlich geringere Grundfläche. Dadurch kann er insbesondere mit Vorteil im Inneren von Gebäuden und in Schaltfeldern angeordnet werden. Durch die Isolierung mit dem Gas SF₆ wird vorteilhafterweise erreicht, dass im Falle eines internen Isolationsfehlers lediglich das Gas aufgrund des entstehenden Überdrucks in die Umgebung entweicht - beispielsweise durch die als Überdruckventil wirkende Berstplatte hindurch. Es wird jedoch - anders als bei einer Ölisolierung - keine zusätzliche Brandlast in Innenräume eingebracht.

Es wurde eine Anordnung und ein Verfahren beschrieben, mit denen insbesondere auf Hochspannungspotential liegende Ströme einfach und preiswert gemessen werden können.

## Patentansprüche

1. Anordnung mit einem Nullflussstromwandler (1), der eine Kompensationswicklung (310) und eine Detektionswicklung (316) aufweist, wobei
- die Kompensationswicklung (310) und die Detektionswicklung (316) in einem Gehäuse (8) angeordnet sind, das von einem vertikal ausgerichteten Stützisolator (12) abgestützt ist, und
- im Inneren des Gehäuses (8) ein Kerngehäuse (20) angeordnet ist, welches die Kompensationswicklung (310) und die Detektionswicklung (316) umgibt,
**dadurch gekennzeichnet, dass**
- das Kerngehäuse (20) mittels SF₆-Gas (48) gegenüber dem Gehäuse (8) elektrisch isoliert ist,
- das Kerngehäuse (20) mittels eines metallischen Rohrs (24) mit Erdpotential (5) verbunden ist,
- das metallische Rohr (24) zumindest teilweise von einer Potentialabsteuereinrichtung (45) umgeben ist,
- das Kerngehäuse (20) mittels eines isolierenden Abstandshalters (28) an einem Deckel (32) des Gehäuses (8) befestigt ist, und
- das Gehäuse (8) mit einer Berstplatte versehen ist, durch die bei Überdruck die Gasfüllung (48) austreten kann, ohne das Gehäuse (8) als solches zu zerstören.

2. Anordnung nach Anspruch 1,
**dadurch gekennzeichnet, dass**
- das Kerngehäuse (20) mittels eines isolierenden Abstandshalters (28) in dem Gehäuse (8) gehaltert ist.

3. Anordnung nach einem der vorhergehenden Ansprüche, **dadurch gekennzeichnet, dass**
- das metallische Rohr (24) zumindest teilweise von dem Stützisolator (12) umgeben ist.

4. Anordnung nach einem der vorhergehenden Ansprüche, **dadurch gekennzeichnet, dass**
- der Stützisolator (12) ein Hohlisolator (12), insbesondere ein mit Schirmen (15) versehener Hohlisolator, ist.

5. Anordnung nach einem der vorhergehenden Ansprüche, **dadurch gekennzeichnet, dass**
- das Gehäuse (8) mit SF₆-Gas (48) gefüllt ist.

6. Anordnung nach einem der vorhergehenden Ansprüche,
**dadurch gekennzeichnet, dass**
- die Detektionswicklung (316) eine eisenkernbehaftete (335) Detektionswicklung ist und der Nullflussstromwandler (1) zusätzlich eine Rogowskispule (330) aufweist.

7. Anordnung nach Anspruch 6,
**dadurch gekennzeichnet, dass**
- die eisenkernbehaftete Detektionswicklung (316) mit einer ersten Messschaltung (420) zum Messen von Gleichstrom elektrisch verbunden ist und die Rogowskispule (330) mit einer zweiten Messschaltung (440) zum Messen von Wechselstrom elektrisch verbunden ist.

8. Anordnung nach Anspruch 7,
**dadurch gekennzeichnet, dass**
die zweite Messschaltung (440) zum Messen von Wechselströmen mit Frequenzen zwischen ca. 10 kHz und 1 MHz eingerichtet ist.

9. Anordnung nach Anspruch 7 oder 8,
**dadurch gekennzeichnet, dass**
- die erste Messschaltung (420) zum Messen von Gleichstrom und zum Messen von Wechselströmen mit Frequenzen zwischen Null und ca. 30 kHz eingerichtet ist.

10. Hochspannungs-Gleichstrom-Energieübertragungseinrichtung mit einer Anordnung nach einem der vorhergehenden Ansprüche.

## Claims

1. Arrangement comprising a zero-flux current transformer (1), which has a compensation winding (310) and a detection winding (316), wherein
- the compensation winding (310) and the detection winding (316) are arranged in a housing (8), which is supported by a vertically oriented supporting insulator (12), and
- a core housing (20), which surrounds the compensation winding (310) and the detection winding (316), is arranged in the interior of the housing (8),
**characterized in that**
- the core housing (20) is electrically insulated with respect to the housing (8) by means of SF₆ gas (48),
- the core housing (20) is connected to earth potential (5) by means of a metal tube (24),
- the metal tube (24) is at least partially surrounded by a potential ramping-down device (45),
- the core housing (20) is secured on a cover (32) of the housing (8) by means of an insulating spacer (28), and
- the housing (8) is provided with a bursting plate, through which the gas filling (48) can escape in the event of overpressure without damaging the housing (8) as such.

2. Arrangement according to Claim 1,
**characterized in that**
- the core housing (20) is held in the housing (8) by means of an insulating spacer (28).

3. Arrangement according to one of the preceding claims,
**characterized in that**
- the metal tube (24) is at least partially surrounded by the supporting insulator (12).

4. Arrangement according to one of the preceding claims,
**characterized in that**
- the supporting insulator (12) is a hollow insulator (12), in particular a hollow insulator provided with shields (15).

5. Arrangement according to one of the preceding claims, **characterized in that**
- the housing (8) is filled with SF₆ gas (48) .

6. Arrangement according to one of the preceding claims, **characterized in that**
the detection winding (316) is an iron-cored (335) detection winding and the zero-flux current transformer (1) additionally has a Rogowski coil (330).

7. Arrangement according to Claim 6,
**characterized in that**
- the iron-cored detection winding (316) is electrically connected to a first measuring circuit (420) for measuring direct current and the Rogowski coil (330) is electrically connected to a second measuring circuit (440) for measuring alternating current.

8. Arrangement according to Claim 7,
**characterized in that**
the second measuring circuit (440) is designed for measuring alternating currents of frequencies between approximately 10 kHz and 1 MHz.

9. Arrangement according to Claim 7 or 8,
**characterized in that**
- the first measuring circuit (420) is designed for measuring direct current and for measuring alternating currents of frequencies between zero and approximately 30 kHz.

10. High-voltage direct-current energy transmission device comprising an arrangement according to one of the preceding claims.

## Revendications

1. Agencement comprenant un transformateur (1) de courant à flux nul, qui a un enroulement (310) de compensation et un enroulement (316) de détection, dans lequel
- l'enroulement (310) de compensation et l'enroulement (316) de détection sont disposés dans un boîtier (8), qui est supporté par un isolateur (12) de support dirigé verticalement, et
- à l'intérieur du boîtier (8) est disposé un boîtier noyau (20), qui entoure l'enroulement (310) de compensation et l'enroulement (316) de détection,
**caractérisé en ce que**
- le boîtier noyau (20) est isolé électriquement du boîtier (8) au moyen de SF₆ gazeux (48),
- le boîtier noyau (20) est mis au potentiel (5) de terre au moyen d'un tube (24) métallique,
- le tube (24) métallique est entouré au moins en partie d'un dispositif (45) de commande de potentiel,
- le boîtier noyau (20) est fixé à un couvercle (32) du boîtier (8) au moyen d'une entretoise (28) isolante, et
- le boîtier (8) est pourvu d'une plaque de rupture, par laquelle, s'il y a une surpression, le remplissage (48) de gaz peut sortir sans détruire le boîtier (8) en tant que tel.

2. Agencement suivant la revendication 1,
**caractérisé en ce que**
- le boîtier noyau (20) est maintenu dans le boîtier (8) au moyen d'une entretoise (28) isolante.

3. Agencement suivant l'une des revendications précédentes, **caractérisé en ce que**
- le tube (24) métallique est entouré au moins en partie de l'isolateur (12) de support.

4. Agencement suivant l'une des revendications précédentes, **caractérisé en ce que**
- l'isolateur (12) de support est un isolateur (12) creux, en particulier un isolateur creux pourvu de blindages (15).

5. Agencement suivant l'une des revendications précédentes, **caractérisé en ce que**
- le boîtier (8) est rempli de SF₆ gazeux (48).

6. Agencement suivant l'une des revendications précédentes, **caractérisé en ce que**
- l'enroulement (316) de détection est un enroulement (335) de détection à noyau de fer et la transformateur (1) de courant à flux nul a en outre une bobine (330) de Rogowski.

7. Agencement suivant la revendication 6,
**caractérisé en ce que**
- l'enroulement (316) de détection à noyau de fer est, pour la mesure du courant continu, relié électriquement a un premier montage (420) de mesure et la bobine (330) de Rogowski est, pour la mesure du courant alternatif, reliée électriquement à un deuxième montage (440) de mesure.

8. Agencement suivant la revendication 7,
**caractérisé en ce que**
le deuxième montage (440) de mesure est agencé pour la mesure de courant alternatif d'une fréquence comprise entre environ 10 kHz et 1 MHz.

9. Agencement suivant la revendication 7 ou 8,
**caractérisé en ce que**
- le premier montage (420) de mesure est agencé pour la mesure de courants continus et pour la mesure de courants alternatifs de fréquences comprises entre zéro et environ 30 kHz.

10. Dispositif de transport d'énergie à courant continu en haute tension ayant un agencement suivant l'une des revendications précédentes.
